# EUROPEAN PATENT APPLICATION

(11) **EP 4 672 241 A1**
(43) Date of publication of application: **31.12.2025**
(21) Application number: 23932834.7
(22) Date of filing: 11.12.2023
(51) Int. Cl.: G11C 5/02

(54) **MEMORY MODULE AND ELECTRONIC DEVICE**

(30) Priority: 10.04.2023 CN 202310429888
(71) Applicant: HUAWEI TECHNOLOGIES CO., LTD., Shenzhen, Guangdong 518129 (CN)
(72) Inventor: HU, Jing, Shenzhen, Guangdong 518129 (CN); ZHONG, Junwei, Shenzhen, Guangdong 518129 (CN); ZHU, Qingfeng, Shenzhen, Guangdong 518129 (CN); LIU, Tuanqing, Shenzhen, Guangdong 518129 (CN)
(74) Representative: Grünecker Patent- und Rechtsanwälte PartG mbB
(86) International application number: PCT/CN2023/137867
(87) International publication number: WO 2024/212563

(57) **Abstract**

Embodiments of this application disclose a memory module and an electronic device, to meet a requirement of a high-density small space. The memory module provided in embodiments of this application includes a first assembly, and the first assembly includes a first module PCB and at least one first memory chip. The first module PCB includes a first memory region and a first connection region, and the first connection region includes a first solder joint array. The first memory region is configured to mount the at least one first memory chip, and the first solder joint array is configured to implement a connection between the first module PCB and a target circuit board, to establish a communication connection between the first module PCB and the target circuit board.

## Description

This application claims priority to Chinese Patent Application No. CN202310429888.X, filed with the China National Intellectual Property Administration on April 10, 2023 and entitled "MEMORY MODULE AND ELECTRONIC DEVICE", which is incorporated herein by reference in its entirety.

### TECHNICAL FIELD

This application relates to the communication field, and in particular, to a memory module and an electronic device.

### BACKGROUND

With development of the Internet, big data and massive data of cloud computing impose higher requirements on processor performance. A quantity of double data rate (double data rate, DDR) memory chips of a processor increases, to facilitate storage of massive data. This brings challenges to a quantity of channels and a capacity of a DDR memory. How to implement a plurality of channels and a large capacity of the DDR memory in a high-density small space becomes an urgent problem to be resolved.

A conventional dual-inline memory module (dual-inline memory modules, DIMM) includes a gold finger. The gold finger is configured to insert into an insertion slot on a substrate, to establish a communication connection between the DIMM and the substrate. Regardless of that a vertical insertion manner, a horizontal insertion manner, or an oblique insertion manner is used, a combination manner of the gold finger and the insertion slot has a problem of a large area, and cannot meet a requirement of a high-density small space.

### SUMMARY

This application provides a memory module and an electronic device. A memory chip in the memory module is mounted in a memory region on a module PCB, and a communication connection to a target circuit board is implemented through a solder joint array in a connection region on the module PCB. No gold finger or insertion slot needs to be disposed, and an area of a connection region in the memory module is smaller. In this way, in a case of a module PCB with a same area, more memory chips can be mounted, to meet a requirement of a high-density small space.

A first aspect of this application provides a memory module, including a first assembly, where the first assembly includes a first module printed circuit board (printed circuit board, PCB) and at least one memory chip. The memory chip is a basic unit for forming a memory module, and may also be briefly referred to as a chip. The memory chip is a single double-data-rate synchronous dynamic random access memory (double-data-rate synchronous dynamic random access memory, DDR SDRAM) chip. The DDR chip includes a single-die package (single-die package, SDP)-type memory chip, a dual-die package (dual-die package, DDP)-type memory chip, a multi-die chip, a multi-layer chip (for example, a 3DS chip), and the like. This is not specifically limited herein. The first module PCB includes a first memory region and a first connection region. The first memory region is configured to mount the at least one first memory chip, to store data. The first connection region includes a first solder joint array. The first solder joint array is configured to implement a connection between the first module PCB and a target circuit board, to establish a communication connection between the first module PCB and the target circuit board. The target circuit board may perform a read/write operation on data in the memory chip mounted on the first module PCB. The target circuit board may be a substrate, or may be a main board. In addition, the target circuit board may alternatively be a module PCB. This is not specifically limited herein. The solder joint array may also be referred to as a pad array.

It can be learned from the foregoing technical solutions that, this application has the following advantages: the memory chip in the memory module is mounted in the memory region on the module PCB, and a communication connection between the module PCB and the target circuit board is implemented through the solder joint array in the connection region on the module PCB. No gold finger or insertion slot needs to be disposed, and an area of the connection region in the memory module is smaller. In this way, in a case of a module PCB with a same area, more memory chips can be mounted, to meet a requirement of a high-density small space.

In a possible implementation of the first aspect, the first assembly further includes at least one connector, and the connector is configured to connect the first solder joint array to the target circuit board. That is, that the first solder joint array is configured to implement the connection between the first module PCB and the target circuit board is completed by connecting the first solder joint array to the target circuit board through the at least one connector. The at least one connector is located between the first solder joint array and the target circuit board.

In this application, the memory module is connected to the target circuit board through the connector. In comparison with a combination manner of a gold finger and an insertion slot, a size of the connector is smaller, and the area of the connection region in the memory module is smaller. This reduces a size of the module PCB. In addition, in a case of a module PCB with a same area, more memory chips can be mounted on the memory module provided in this application, to further meet a requirement of a high-density small space.

In a possible implementation of the first aspect, each of the at least one connector includes a first baffle pate. A via is provided in the first enclosure baffle board, and the via of the first enclosure baffle board is soldered to the first solder joint array and the target circuit board. The solder joint array is an array including a plurality of solder joints, and each solder joint is used to mark a connection location. The first solder joint array on the first module PCB corresponds to the via on the first enclosure baffle board. The via of the first enclosure baffle board is filled with a conductive material, for example, copper or gold. This is not specifically limited herein. The first solder joint array, the via of the first enclosure baffle board, and the target circuit board are aligned, so that it can be ensured that a communication connection between the first module PCB and the target circuit board is normally established. This solder manner is also referred to as a surface mounted technology (surface mounted technology, SMT). In this application, the solder manner specifically means that the connector is soldered between the target circuit board and the first module through solder paste. In addition, the first enclosure baffle board in this application may alternatively be a PCB board.

In this application, the first module PCB may be connected to the target circuit board in a manner of soldering through the enclosure baffle board. A solder manner is simple, and costs are reduced.

In a possible implementation of the first aspect, each of the at least one connector includes a single-sided elastic connection member. The single-sided elastic connection member may be a dedicated connector, or may be formed by adding a spring plate to a single surface of an baffle PCB board. This is not specifically limited herein. The single-sided elastic connection member may be connected to the first module PCB and the target circuit board in a plurality of possible manners. The manner may be: An elastic surface of the single-sided elastic connection member is connected to the first connection region, and a non-elastic surface of the single-sided elastic connection member is soldered to the target circuit board. That is, a spring plate of the elastic surface of the single-sided elastic connection member is in contact with the first solder joint array in the first connection region, and the non-elastic surface is soldered to the target circuit board. The manner may alternatively be: An elastic surface of the single-sided elastic connection member may be connected to the target circuit board, and a non-elastic surface of the single-sided elastic connection member is soldered to the first connection region. That is, a spring plate of the elastic surface of the single-sided elastic connection member is in contact with the target circuit board, and the non-elastic surface is soldered to the first solder joint array in the first connection region.

In this application, the first module PCB is connected to the target circuit board through the single-sided elastic connection member, so that the memory module and the target circuit board can be decoupled. This facilitates disassembly and is more convenient in scenarios such as production, testing, and maintenance. This improves practicability of the technical solutions of this application. In addition, if the baffle PCB board is used to replace a dedicated connector, a dedicated connector for mold opening is not required, and locations and a quantity of solder joints, namely, locations and a quantity of pins (PINs), can be flexibly set. This further improves flexibility of the technical solutions of this application.

In a possible implementation of the first aspect, each of the at least one connector includes a dual-sided elastic connection member. The dual-sided elastic connection member may be a dedicated connector, or may be formed by adding spring plates to two surfaces of an baffle PCB board. This is not specifically limited herein. The dual-sided elastic connection member is connected to the first connection region and the target circuit board. Specifically, a spring plate on one surface of the dual-sided elastic connection member is in contact with the first solder joint array in the first connection region, and a spring plate on the other surface is in contact with the target circuit board.

In this application, the connector may alternatively be the dual-sided elastic connection member, and a communication connection between the first module PCB and the target circuit board is established through contact between the spring plates on the two surfaces. In this way, maintenance and replacement of the connector are more convenient, and practicability of the technical solutions of this application is further improved. In addition, if the baffle PCB board is used to replace a dedicated connector, a dedicated connector for mold opening is not required, and locations and a quantity of solder joints can be flexibly set. This further improves flexibility of the technical solutions of this application.

In a possible implementation of the first aspect, each of the at least one connector includes a second enclosure baffle board, and each connector further includes a first conductive layer and/or a second conductive layer. In other words, the connector may include the second enclosure baffle board and a first conductive layer, or include the second enclosure baffle board and a second conductive layer, or include the second enclosure baffle board, a first conductive layer, and a second conductive layer. The first conductive layer and the second conductive layer are conductive fabrics or conductive films, a via may be provided in plastic, and the via is filled with a conductive material. A via is also provided on the second enclosure baffle board, and the via is filled with a conductive material. The first conductive layer is configured to connect the second enclosure baffle board to the target circuit board, and the second enclosure baffle board is further soldered to the first solder joint array. Specifically, a via of the first conductive layer, the via of the second enclosure baffle board, and the target circuit board are aligned in a crimping manner. The second conductive layer is connected to the second enclosure baffle board and the first solder joint array, and the second enclosure baffle board is further soldered to the target circuit board. Specifically, a via of the second conductive layer, the via of the second enclosure baffle board, and the first solder joint array in the first connection region are aligned in a crimping manner.

In this application, the connector may alternatively include the second enclosure baffle board and a conductive layer. An appearance of the conductive layer supports free cutting. This enriches application scenarios of the technical solutions of this application, and further improves flexibility. In addition, with reference to the foregoing plurality of implementations, in this application, there are a plurality of possible connectors. The connector may be flexibly selected according to an actual application requirement.

In a possible implementation of the first aspect, the memory module further includes a second assembly. The second assembly includes a second module PCB and at least one second memory chip. A plane on which the second module PCB is located intersects a plane on which the first module PCB is located. The first connection region on the first module PCB further includes a second solder joint array, and the second solder joint array and the first solder joint array are located on different surfaces of the first module PCB. The at least one second memory chip is mounted on the first module PCB. The second solder joint array is configured to connect the first module PCB to the second module PCB.

In this application, the memory module may include a single module PCB, or may include a plurality of module PCBs. When the plurality of module PCBs are included, planes on which the plurality of module PCBs are located may be parallel or intersect. This enriches implementations of the technical solutions of this application.

In a possible implementation of the first aspect, the first solder joint array is configured to implement a connection between the first module PCB and the target circuit board, which may be soldering the first solder joint array to the target circuit board. That is, the first assembly may alternatively be directly soldered to the target circuit board without a connector. In this case, the first memory chip and the first solder joint array are located on different surfaces of the first module PCB, that is, the first memory chip is mounted on a single surface of the first module PCB.

In a possible implementation of the first aspect, the first memory region is located on a single surface or both surfaces of the first module PCB. That is, the first module PCB supports single-sided or dual-sided mounting of memory chips.

In this application, first memory chips may be mounted on the single surface or the both surfaces of the first module PCB. This further enriches application scenarios of the technical solutions of this application. In addition, dual-sided mounting can further expand a capacity of the memory module.

In a possible implementation of the first aspect, the first assembly may be packaged. In other words, the memory module further includes a package housing, and the package housing includes the first assembly.

In this application, the memory module supports an open frame manner. This facilitates heat dissipation of the memory module. The module PCB included in the memory module may alternatively be packaged, to provide physical support and electrical protection. This reduces external interference.

A second aspect of this application provides an electronic device, including a main board, a processor, a housing, and at least one memory module according to any one of the first aspect and the implementations of the first aspect. The memory module is electrically connected to the processor through the main board, the memory module is configured to store data, and the processor is configured to process the data in the memory module.

Beneficial effects shown in this aspect are similar to those in the first aspect and any possible implementation of the first aspect. Details are not described herein again.

### BRIEF DESCRIPTION OF DRAWINGS

FIG. 1 is a diagram of an application scenario of a memory module according to an embodiment of this application;
FIG. 2 is a diagram of another application scenario of a memory module according to an embodiment of this application;
FIG. 3 is a diagram of a memory module according to an embodiment of this application;
FIG. 4 is a top view of a memory module according to an embodiment of this application;
FIG. 5 is another diagram of a memory module according to an embodiment of this application;
FIG. 6 is another diagram of a memory module according to an embodiment of this application;
FIG. 7 is another diagram of a memory module according to an embodiment of this application;
FIG. 8 is another diagram of a memory module according to an embodiment of this application;
FIG. 9 is another diagram of a memory module according to an embodiment of this application;
FIG. 10 is another diagram of a memory module according to an embodiment of this application;
FIG. 11 is another top view of a memory module according to an embodiment of this application;
FIG. 12 is another top view of a memory module according to an embodiment of this application;
FIG. 13 is another diagram of a memory module according to an embodiment of this application;
FIG. 14 is another diagram of a memory module according to an embodiment of this application;
FIG. 15a is another diagram of a memory module according to an embodiment of this application;
FIG. 15b is another diagram of a memory module according to an embodiment of this application;
FIG. 16 is a diagram of a processing procedure of a memory module according to an embodiment of this application;
FIG. 17 is a diagram of a main board according to an embodiment of this application;
FIG. 18 is a diagram of routing for a memory module according to an embodiment of this application;
FIG. 19a is a diagram of routing for a memory module according to an embodiment of this application; and
FIG. 19b is a diagram of routing for a memory module according to an embodiment of this application.

### DESCRIPTION OF EMBODIMENTS

This application provides a memory module and an electronic device. A memory chip in the memory module is mounted in a memory region on a module PCB, and a communication connection to a target circuit board is implemented through a solder joint array in a connection region on the module PCB. No gold finger or insertion slot needs to be disposed, and an area of a connection region in the memory module is smaller. In this way, in a case of a module PCB with a same area, more memory chips can be mounted, to meet a requirement of a high-density small space.

The following describes embodiments of this application with reference to the accompanying drawings. A person of ordinary skill in the art may learn that, with development of technologies and emergence of a new scenario, the technical solutions provided in embodiments of this application are also applicable to a similar technical problem.

In the specification, claims, and the accompanying drawings of this application, the terms "first", "second", and the like are intended to distinguish between similar objects but do not necessarily indicate a specific order or sequence. It should be understood that the terms used in such a way are interchangeable in proper circumstances, and this is merely a discrimination manner for describing objects with a same attribute in embodiments of this application. In addition, the terms "include", "contain" and any other variants mean to cover the non-exclusive inclusion, so that a process, method, system, product, or device that includes a series of units is not necessarily limited to those units, but may include other units not expressly listed or inherent to such a process, method, product, or device. In addition, "at least one" means one or more, and "a plurality of" means two or more. "And/or" describes an association relationship between associated objects and indicates that three relationships may exist. For example, A and/or B may indicate the following cases: Only A exists, both A and B exist, and only B exists, where A and B may be singular or plural. The character "/" usually indicates an "or" relationship between the associated objects. "At least one of the following items (pieces)" or a similar expression thereof indicates any combination of these items, including a single item (piece) or any combination of a plurality of items (pieces). For example, at least one item (piece) of a, b, or c may indicate: a, b, c, a and b, a and c, b and c, or a, b, and c, where a, b, and c may be singular or plural.

First, a proper noun or a related concept that may be used in this application is described.

A double-data-rate synchronous dynamic random access memory (double-data-rate synchronous dynamic random access memory, DDR SDRAM) is briefly referred to as a DDR memory. Double-data-rate means that a bi-directional data strobe (bi-directional data strobe, DQS) clock samples data signals at both a rising edge and a falling edge. In other words, data is transmitted twice in a clock cycle. Synchronous means that clock synchronization is required when a memory operates. Internal-command sending and data transmission are based on a clock. A clock edge is used for sampling. Dynamic means that a dynamic random access memory (dynamic random access memory, DRAM) needs to be refreshed periodically, so that information stored in a capacitor is not lost. Random access means that when a message in a memory is read or written, a needed time is irrelevant to a location of the information. Currently, a generation of the DDR memory develops from a DDR1 to a DDR5. An operating voltage is continuously reduced, a clock frequency and a data transmission rate are continuously increased, and a capacity is continuously increased.

A memory channel (channel) is a DDR memory controller and a memory corresponding to the memory controller. One processor (central processing unit, CPU) corresponds to a plurality of DDR channels. Data bit widths of the plurality of channels are usually the same and independent of each other. Usually, a data bit width of a channel is 32 bits or 64 bits. Commonly known dual-channel means that a CPU has two completely independent memory controllers.

A memory rank (rank) is a group of memory chips that can operate in parallel to meet a data bit width requirement of a CPU memory controller. If a data bit width of the CPU memory controller is 64 bits, a bit width of a single memory chip is usually 4 bits, 8 bits, or 16 bits. To implement a 64-bit data width, four 16-bit memory chips, eight 8-bit memory chips, or sixteen 4-bit memory chips are needed. In addition, to ensure memory data integrity and recover memory errors, an 8-bit memory chip may be further added to a group of memory chips, to store an error correction code (error correction code, ECC). With reference to the foregoing description of the memory channel, it can be learned that a relationship between a memory channel, a memory module, a memory rank, and a memory chip is as follows: One memory channel includes at least one memory module, the memory module includes a memory rank, and the memory rank includes at least one memory chip.

High-density interconnect (high-density interconnects, HDI): HDI wiring is a high-density design and a special process technology, to implement a denser design without affecting functions of a circuit. In the HDI, a plurality of routing layers, a trace with a smaller size, a via, a pad, and a thinner substrate are used, so that a high-density circuit is arranged on a PCB with a smaller area. In addition, based on the HDI technology, a memory chip on one surface of a module PCB is not affected by a via on the other surface of the module PCB, and no electrical short circuit occurs. In this way, a layout is more compact, thereby implementing a high-density layout.

Plated over filled via (plated over filled via, POFV) means filling a through via with resin and then performing plating to cover the resin, and is a type of via-in-pad and also a special process technology for resolving a problem of locally high density. Based on the POFV, a pad of a connector is disposed on the via, to reduce a size of a component. In the memory module provided in this application, the memory chip may be mounted to the module PCB by using a process, for example, the HDI or the POFV.

A surface mounted technology (surface mounted technology, SMT) means mounting an electronic component or a module to a board through solder paste, and includes a dual-sided SMT and a single-sided SMT.

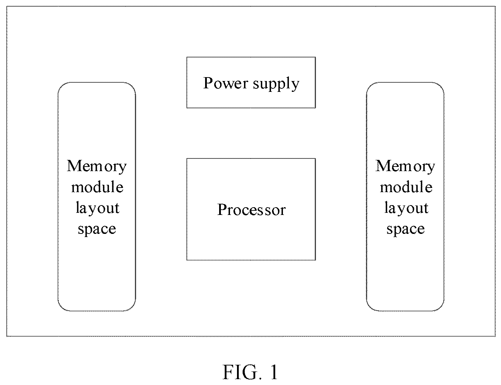

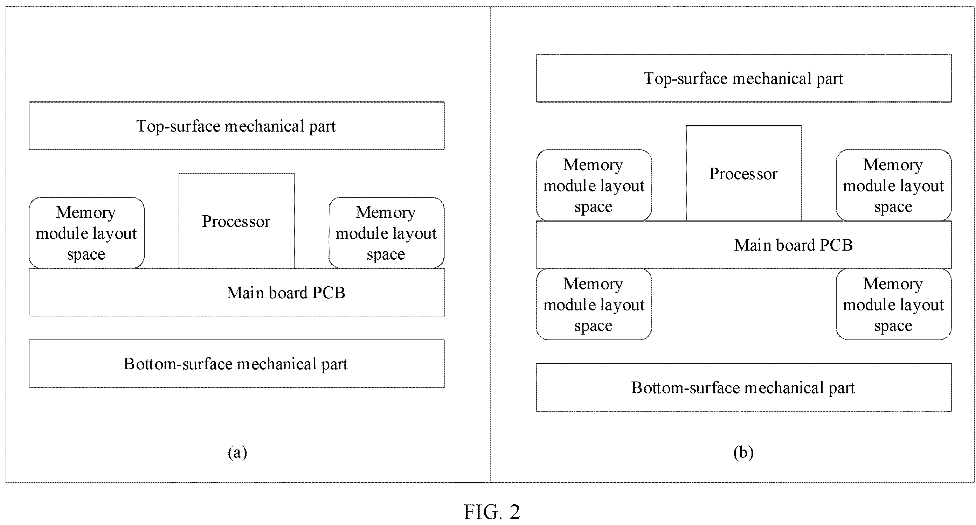

The memory module provided in this application is used in a high-density scenario. The following describes a typical application scenario with reference to a diagram. Refer to FIG. 1 and FIG. 2. FIG. 1 and FIG. 2 each are a diagram of a scenario in which the memory module provided in this application is used. FIG. 1 is a top view, and FIG. 2 is a side view.

The memory module provided in this application may be used in a high-density scenario, for example, a standard add-in card (add-in card), a board, a main board (main board), or a CPU module (CPU module). These scenarios may be abstracted as FIG. 1 in which a processor and a power supply are included, and a memory module layout space is provided. The power supply provides power for the processor to ensure that the processor can operate normally. The memory module layout space is used to place the memory module, the memory module is configured to store data, and the processor performs a read operation on the data stored in the memory module.

There are a plurality of possible locations of the memory module on a component. As shown in (a) in FIG. 2, memory module layout spaces may be provided only on a single surface of a main board PCB. As shown in (b) in FIG. 2, memory module layout spaces may alternatively be provided on both surfaces of a main board PCB. In addition, a mechanical part is further disposed on a top surface or a bottom surface of the main board PCB, and a height limit requirement is imposed between the mechanical part and the main board PCB, that is, a height of the memory module layout space is limited. For example, in the embodiment shown in (a) in FIG. 2, a height limit between the main board PCB and a top-surface mechanical part is approximately 5 mm, and a height limit between the main board PCB and a bottom-surface mechanical part is approximately 2 mm. In the embodiment shown in (b) in FIG. 2, a height limit between the main board PCB and a top-surface mechanical part and a height limit between the main board PCB and a bottom-surface mechanical part are similar, and are both approximately 5 mm.

It should be noted that, in different components, values of height limits are also different. For example, in a standard add-in card scenario, a top-surface height limit of the main board PCB is approximately 14 mm. In a board or main board scenario, a top-surface height limit of the main board PCB is approximately 11 mm. In addition, in FIG. 2, a case in which the component further includes the mechanical part is considered. When the component does not include a mechanical part or a size of a mechanical part is small, a height limit of the memory module layout space may be higher. For example, a height limit of the memory module layout space may be equivalent to a width of a single slot occupied by a standard card, and is approximately 14 mm. Alternatively, a height limit of the memory module layout space may be equivalent to a width of double slots occupied by a standard card, and is approximately 28 mm.

In addition, in different components, areas of memory module layout spaces are also different. For example, in a standard card scenario, a memory module layout space on a single side of the processor is approximately 40 mm×70 mm. In a board or main board scenario, a memory module layout space on a single side of the processor is approximately 25 mm×150 mm. In a CPU module scenario, a memory module layout space on a single side of the processor is approximately 40 mm×130 mm.

A quantity and an arrangement manner of memory modules on the component vary with a quantity of DDR channels supported by the processor and a quantity of DDR channels supported by the memory module. For example, it is assumed that the processor has four DDR channels, and the four DDR channels are located on two sides of the processor. In this case, two DDR channels may be arranged on each side of the processor. If the memory module supports a single DDR channel, two memory modules are arranged on each side of the processor. If the memory module supports two DDR channels, one memory module is arranged on each side of the processor, to further implement a high-density layout.

It should be noted that FIG. 1 and FIG. 2 are merely examples of the high-density scenario in which the memory module provided in this application is used, and listed data such as a length, a width, and a height does not constitute a limitation on actual application. During actual application, the processor may further support more or fewer DDR channels, and each memory module may further support more DDR channels. This is not specifically limited herein. In addition, during actual application, there may be another high-density scenario, and a size limitation on the memory module in the another high-density scenario may be different from that in FIG. 1 and FIG. 2. This is not specifically limited herein.

The following describes the memory module provided in embodiments of this application. In summary, the memory module provided in embodiments of this application may include a single module PCB, or may include a plurality of module PCBs. The following separately describes possible cases.

### I. A memory module includes a single module PCB.

In this case, a target circuit board includes a main board or a substrate, and the memory module and the target circuit board may be connected in a plurality of manners. The memory module and the target circuit board may be directly soldered, or may be connected to each other through a connector. This is not specifically limited herein. The main board herein is a main board in a high-density scenario. In addition to the memory module, the main board is further connected to a CPU. The substrate herein is a package substrate of a die (die), and the package substrate is further connected to the main board. The following separately describes possible cases in which the memory module includes a single module PCB.

### 1. A memory module is connected to a target circuit board through a connector.

In this case, the memory module includes a first assembly, and the first assembly includes a first module PCB, at least one first memory chip, and at least one connector.

The first module PCB includes a first memory region and a first connection region. The first memory region is configured to mount the at least one first memory chip, to store data. The memory chip is a basic unit for forming a memory module, and may also be briefly referred to as a chip. The memory chip is a DDR SDRAM chip, and may be briefly referred to as a DDR chip. The DDR chip includes an SDP-type memory chip, a DDP-type memory chip, a multi-die chip, a multi-layer chip (for example, a 3DS chip), and the like. This is not specifically limited herein. Compared with the SDP chip, another type of memory chip has a larger capacity and load, imposes a stricter requirement on a routing topology of the target circuit board, and is added with a routing layer during mounting.

The first connection region is configured to connect to the at least one connector, and the at least one connector is further connected to the target circuit board, to establish a communication connection between the first module PCB and the target circuit board. The first module PCB is parallel to the target circuit board.

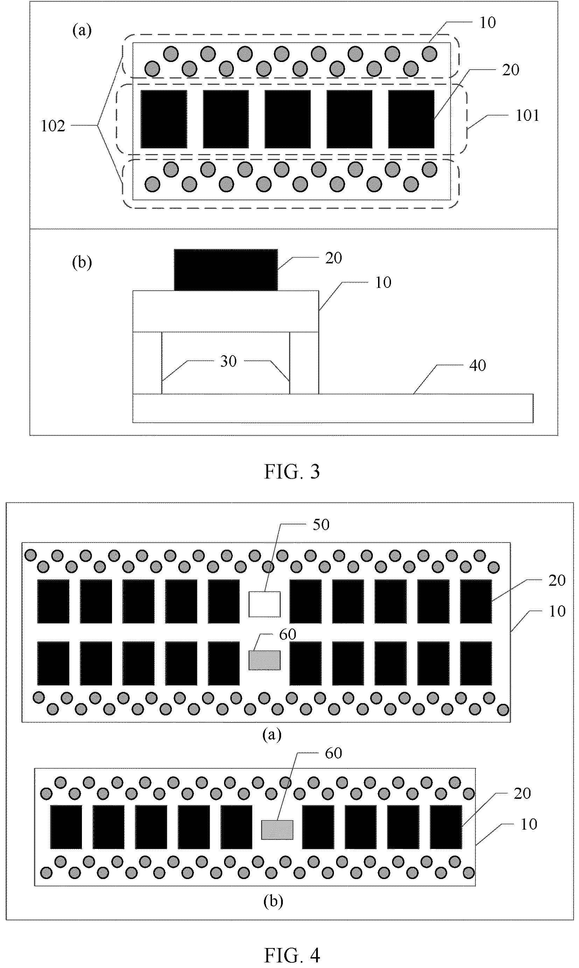

For clarity of description, the following further describes the memory module with reference to a diagram. Refer to FIG. 3. FIG. 3 is a diagram of a memory module according to an embodiment of this application. (a) in FIG. 3 is a top view of the memory module, and (b) in FIG. 3 is a side view of the memory module and a target circuit board.

As shown in FIG. 3, the memory module includes a first module PCB 10, a first memory chip 20, and a connector 30. The first module PCB 10 includes a first memory region 101 and a first connection region 102. The first memory region 101 is configured to mount a plurality of first memory chips 20, and the connector 30 is configured to connect the first memory region 101 and the target circuit board 40.

In the embodiment shown in FIG. 3, the first connection region 102 includes a first solder joint array, and the first solder joint array is located on two sides of the first memory region 101. Gray dots in (a) in FIG. 3 indicate solder joints, a plurality of solder joints form a solder joint array, and the solder joint array is used to identify a connection location. In other words, that the first connection region 102 is connected to the connector 30 is actually implemented through the first solder joint array.

In FIG. 3, an example in which the first module PCB 10 includes five first memory chips 20, and a long edge of each first memory chip 20 is perpendicular to a long edge of the first module PCB 10 is used. In this case, the first module PCB 10 may be approximately 63 mm in length and approximately 23 mm in width.

During actual application, the first module PCB 10 may further mount more first memory chips 20. This is not specifically limited herein. For example, refer to FIG. 4. FIG. 4 is a diagram of a memory module according to an embodiment of this application. In both (a) in FIG. 4 and (b) in FIG. 4, a top view of the memory module is use as an example.

In the embodiment shown in (a) in FIG. 4, double rows of first memory chips 20 are mounted on one surface of a first module PCB 10, and each row has 10 first memory chips 20. The first module PCB 10 is approximately 130 mm in length and approximately 38 mm in width. In this structure, 1 to 20 first memory chips 20 may also be mounted on the other surface of the first module PCB 10.

In addition, in the embodiment shown in (a) in FIG. 4, the memory module further includes a driver 50 and an electrically erasable programmable read-only memory (electrically erasable programmable read-only memory, EEPROM) 60. The electrically erasable programmable read-only memory may also be briefly referred to as an E2PROM. The driver 50 is configured to drive memory data. This can reduce load and improve signal quality, to support more chips and increase a memory capacity. The electrically erasable programmable read-only memory 60 is configured to store memory information (for example, configuration information such as a memory rate, a chip bit width, and a rank) of a memory chip. Stable memory information can be provided even if no power is supplied for a long time. When the memory module includes the electrically erasable programmable read-only memory 60, a target circuit board reads memory information and performs basic input/output system (basic input/output system, BIOS) configuration more flexibly and conveniently.

It should be noted that the memory module provided in this application may alternatively not include the driver 50 or the electrically erasable programmable read-only memory 60. An operation principle of a memory module without a driver 50 is similar to that of an unbuffered dual-inline memory module (unbuffered dual-inline memory module, UDIMM). An operation principle of a memory module with a driver 50 is similar to that of a registered dual-inline memory module (registered dual-inline memory module, RDIMM) or a load reduced dual-inline memory module (load reduced dual-inline memory module, LRDIMM).

In the embodiment shown in (b) in FIG. 4, the memory module further includes an electrically erasable programmable read-only memory 60. Nine first memory chips 20 are mounted on one surface of a first module PCB. The first module PCB 10 is approximately 120 mm in length and approximately 23 mm in width. In this structure, 1 to 9 first memory chips 20 may also be mounted on the other surface of the first module PCB 10.

It should be noted that FIG. 3 and FIG. 4 are merely examples of the memory module, and do not constitute a limitation on the memory module. During actual application, the memory module may further include more or fewer first memory chips 20. A layout manner of the first memory chips 20 is not limited to that shown in FIG. 3 or FIG. 4. There are a plurality of possible locations of the first connection region 102 and a plurality of possible arrangement manners of the first solder joint array. This is not specifically limited herein.

The following first describes the first memory chip 20 in detail.

In general, layout locations and a quantity of first memory chips on the first module PCB are not limited. A high-density layout of memory chips can be supported by using processes such as high-density interconnect (high density interconnects, HDI) and plated over filled via (plated over filled via, POFV).

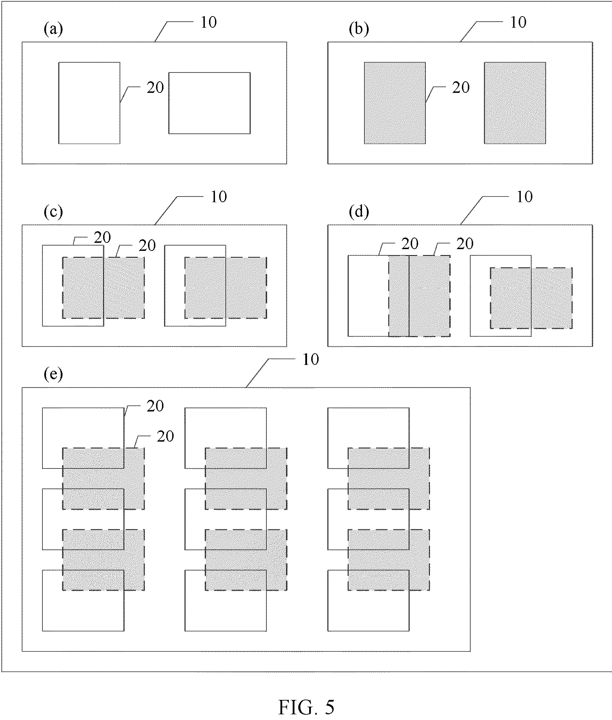

For example, refer to FIG. 5. FIG. 5 is a diagram of a memory module according to an embodiment of this application. In each sub-diagram shown in FIG. 5, a top view of the memory module is used as an example, and FIG. 5 intends to describe diversity of quantities of first memory chips 20 and diversity of layout manners on a first module PCB 10.

In the embodiment shown in FIG. 5, first memory chips 20 mounted on different surfaces are distinguished by using rectangles of different colors. The first memory chips 20 may be mounted on a first surface of the first module PCB 10, as shown in (a) in FIG. 5; or may be mounted on a first surface and a second surface of the first module PCB 10, as shown in (b) in FIG. 5 to (e) in FIG. 5. The first surface of the first module PCB 10 may be a top surface or a bottom surface of the first module PCB 10, where the top surface is briefly referred to as a TOP surface or a T surface, and the bottom surface is briefly referred to as a bottom surface or a B surface. The second surface may be a top surface or a bottom surface of the first module PCB 10, provided that the second surface is different from the first surface. A distance between the top surface and a target circuit board is greater than a distance between the bottom surface and the target circuit board.

During mounting, the first memory chips 20 may have different layouts.

Optionally, in a case in which mounting is performed on a single surface of the first module PCB 10, a long edge of each first memory chip 20 may be perpendicular to a long edge of the first module PCB 10, as shown in FIG. 3 or FIG. 4; or a long edge of each first memory chip 20 may be parallel to a long edge of the first module PCB 10; or similar to (a) in FIG. 5, a long edge of a part of the first memory chips 20 is perpendicular to a long edge of the first module PCB 10, and a long edge of the other part of the first memory chips 20 is parallel to the long edge of the first module PCB 10. In addition, there is another possible arrangement manner of the first memory chips 20. For example, a long edge of the first memory chip 20 is neither perpendicular to nor parallel to the long edge of the first module PCB 10. This is not specifically limited herein.

Optionally, in a case in which mounting is performed on both surfaces of the first module PCB 10, a first memory chip 20 mounted on the T surface and a first memory chip 20 mounted on the B surface may completely overlap, as shown in (b) in FIG. 5; or may not completely overlap, as shown in (c) in FIG. 5 and (d) in FIG. 5. In a case of not completely overlapping, mounting manners and quantities of first memory chips 20 mounted on the T surface and first memory chips 20 mounted on the B surface may be the same or different. This is not specifically limited herein.

In this application, the first memory chips 20 may be mounted on the single surface or the both surfaces of the first module PCB 10. This enriches application scenarios of the technical solutions of this application. In addition, dual-sided mounting can further expand a capacity of the memory module.

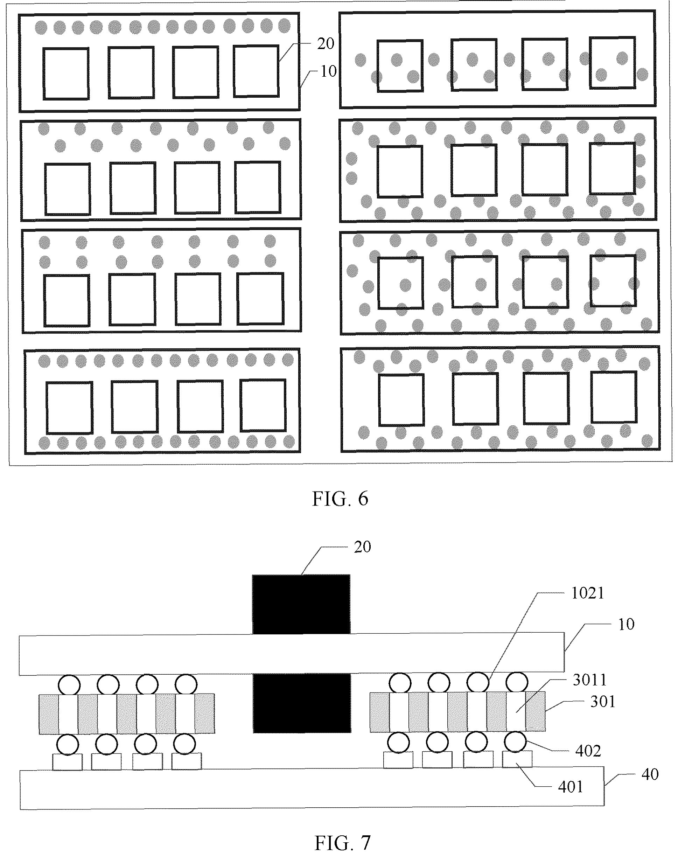

Next, with reference to FIG. 6, arrangement of solder joints or solder balls in a first solder joint array included in a first connection region is described in detail.

In addition to being connected to a target circuit board, the memory module provided in this application may be further connected to a chip (for example, a CPU) on the target circuit board. In other words, the solder joints of the first connection region have two purposes. When the CPU on the target circuit board is connected, a pin (PIN) in the first connection region included in a first module PCB 10 is manufactured in a manner of a solder joint, a solder ball, or the like.

In FIG. 6, an example in which a first memory chip 20 is mounted on a T surface of the first module PCB, and PINs are arranged on a B surface is used. As shown in FIG. 6, there are a plurality of pin arrangement cases, including: single-side single-row arrangement, single-side multi-row pin-staggered arrangement, single-side multi-row pin-aligned arrangement, and dual-side single-row arrangement that are respectively shown from top to bottom in four sub-diagrams on a left side in FIG. 6; and pins being centered inside, pins being on an outer circle, pins being arranged inside and outside, and dual-side multi-row arrangement that are respectively shown from top to bottom in four sub-diagrams on a right side in FIG. 6. This is not specifically limited herein.

In a case in which the first module PCB 10 is connected to the target circuit board through a connector, a specific connection manner varies with the connector. The following separately describes possible cases.

### 1.1. A connector includes a first enclosure baffle board.

In some optional implementations, each of at least one connector includes a first enclosure baffle board. A via is provided in the first enclosure baffle board, and the via of the first enclosure baffle board is soldered to a first solder joint array in a first connection region, and a target circuit board.

The following provides a description with reference to a diagram. Refer to FIG. 7. FIG. 7 is a diagram of a memory module according to this application. FIG. 7 is a side view of the memory module, and an example in which first memory chips are mounted on both surfaces of a first module PCB 10 is used.

Specifically, a first connection region may include a first solder joint array. The solder joint array is an array including a plurality of solder joints 1021, and each solder joint 1021 is used to mark a connection location. As shown in FIG. 7, the first solder joint array on the first module PCB 10 corresponds to a via 3011 on a first enclosure baffle board 301 and a pad 401 on a target circuit board 40. The first solder joint array, the via 3011 of the first enclosure baffle board 301, and the pad 401 of the target circuit board 40 are aligned, so that it can be ensured that a communication connection between the first module PCB 10 and the target circuit board 40 is normally established. The via 3011 is filled with a conductive material, for example, copper or gold. This is not specifically limited herein. In addition, the first enclosure baffle board 301 in this application may alternatively be a PCB board.

Optionally, in a process of soldering the first module PCB 10, the first enclosure baffle board 301, and the target circuit board 40, the first module PCB 10 and the first enclosure baffle board 301 may be first soldered by using an SMT, and then a soldered entire component is soldered to the target circuit board 40 by using an SMT; or the first enclosure baffle board 301 and the target circuit board 40 may be first soldered by using an SMT, and then the first enclosure baffle board 301 and the first module PCB 10 are soldered. This is not specifically limited herein. When the first enclosure baffle board 301 is soldered to the target circuit board 40, the via 3011, a solder joint 402, and the pad 401 may be aligned.

In some optional implementations, a height of the first memory chip 20 is approximately 1.2 mm, and a height of the first enclosure baffle board 301 and a height of the first module PCB 10 are both approximately 1.4 mm. If heights of a solder ball and a solder joint are ignored, an overall height of the memory module is approximately 4 mm. This can meet a height limit requirement of a high-density space.

In this application, the first module PCB 10 may be connected to the target circuit board 40 in a manner of soldering through the enclosure baffle board. A solder manner is simple, and costs are reduced.

### 1.2. A connector includes a single-sided elastic connection member.

In some optional implementations, each of at least one connector includes a single-sided elastic connection member. An elastic surface of the single-sided elastic connection member is connected to a first solder joint array, and a non-elastic surface of the single-sided elastic connection member is soldered to a pad of a target circuit board. Alternatively, an elastic surface of the single-sided elastic connection member is connected to a target circuit board, and a non-elastic surface of the single-sided elastic connection member is soldered to a first solder joint array. The single-sided elastic connection member may be a dedicated connector, or may be formed by adding a spring plate to a single surface of an baffle PCB board. This is not specifically limited herein.

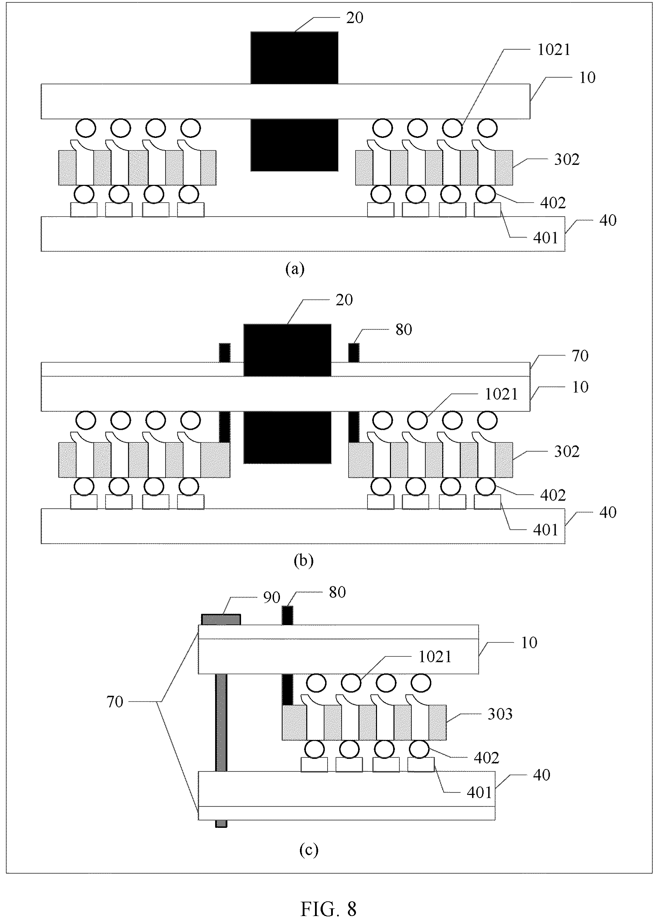

The following provides a description with reference to a diagram by using an example in which the elastic surface of the single-sided elastic connection member is connected to a first solder region, and the non-elastic surface is soldered to the target circuit board. Refer to FIG. 8. FIG. 8 is a diagram of a memory module according to this application. FIG. 8 includes a side view of the memory module, and an example in which first memory chips 20 are mounted on both surfaces of a first module PCB 10 is used.

As shown in (a) in FIG. 8, a spring plate or a spring pin on an elastic surface of a single-sided elastic connection member 302 is in contact with a first solder joint array in a first connection region, and a non-elastic surface is soldered to a pad 401 of a target circuit board 40, so that a communication connection between the first module PCB 10 and the target circuit board 40 is established. A solder joint 1021 is included in the first solder joint array.

In some optional implementations, as shown in (b) in FIG. 8, a guide pin hole may be further provided on the first module PCB 10, and the guide pin hole is configured to insert a guide pin 80, to align the first module PCB 10 with the target circuit board 40. The guide pin 80 is connected to the first module PCB 10 and the single-sided elastic connection member 302 through the guide pin hole.

It should be noted that, in the embodiment shown in (b) in FIG. 8, a reason why a guide pin hole is not provided on the target circuit board 40 either is that in this case, the single-sided elastic connection member 302 is soldered to the pad 401 of the target circuit board 40, and the single-sided elastic connection member 40 and the pad 401 are aligned. In other words, when the elastic surface of the single-sided elastic connection member 302 is connected to the target circuit board 40, and the non-elastic surface of the single-sided elastic connection member 302 is soldered to the first connection region, that is, when the spring plate or the spring pin on the elastic surface of the single-sided elastic connection member 302 is in contact with the pad 401 of the target circuit board 40, and the non-elastic surface is soldered to the first solder joint array of the first connection region, a guide pin hole may be started on the target circuit board 40, and the guide pin 80 is connected to the target circuit board 40 and the single-sided elastic connection member 302 through the guide pin hole.

In some optional implementations, as shown in (c) in FIG. 8, a screw hole may be further provided on the first module PCB 10, and is configured to insert a screw 90, to reinforce a connection between the memory module and the target circuit board 40. The screw 90 is connected to the first module PCB 10 and the target circuit board 40 through the screw hole. A type of the screw 90 is not limited in this application. During actual application, for consideration of component miniaturization, a countersunk screw with a lower height may be used.

In addition, in the embodiment shown in (b) in FIG. 8, the memory module further includes a structural reinforcing plate 70, configured to strengthen a connection between the guide pin 80 and the first module PCB 10 and a connection between the guide pin 80 and the single-sided elastic connection member 302. In the embodiment shown in (c) in FIG. 8, the memory module further includes a structural reinforcing plate 70. The structural reinforcing plate 70 is configured to: strengthen a connection between the guide pin 80 and the first module PCB 10 and a connection between the guide pin 80 and the single-sided elastic connection member 302, and strengthen a connection between the screw 90 and the first module PCB 10 and a connection between the screw 90 and the target circuit board 40. Optionally, a structural reinforcing plate 70 may alternatively not be included in the memory module, but is used as a connection member in an assembly process of the memory module and used in cooperation with the memory module.

In some optional implementations, both a guide pin hole and a screw hole may be provided on the first module PCB 10, or only a guide pin hole or a screw hole may be provided on the first module PCB 10. This is not specifically limited herein.

Optionally, in a process of assembling the single-sided elastic connection member 302 and the target circuit board 40, the spring pin or the spring plate may be aligned with a solder joint 402 and the pad 401, to solder the solder joint 402 to the pad 401.

In some optional implementations, a height of the first memory chip 20 is approximately 1.2 mm, a height of the first module PCB 10 is approximately 1.4 mm, and a height of the single-sided elastic connection member 302 present after crimping is approximately 1.4 mm. If heights of a solder ball and a solder joint are ignored, an overall height of the memory module is approximately 4 mm. This can meet a height limit requirement of a high-density space.

In this application, the first module PCB 10 is connected to the target circuit board 40 through the single-sided elastic connection member 302, so that the memory module and the target circuit board 40 can be decoupled. This facilitates disassembly and is more convenient in scenarios such as production, testing, and maintenance. This improves practicability of the technical solutions of this application. In addition, if the baffle PCB board is used to replace a dedicated connector, a dedicated connector for mold opening is not required, and locations and a quantity of solder joints, namely, locations and a quantity of pins (PINs), can be flexibly set. This further improves flexibility of the technical solutions of this application. In addition, providing a guide pin hole or a screw hole on the first module PCB 10 to insert a guide pin or a screw can further align the first module PCB 10 with the target circuit board 40. This facilitates assembly of the memory module and the target circuit board 40, or enhances connection fastening between the memory module and the target circuit board 40.

### 1.3. A connector includes a dual-sided elastic connection member.

In some optional implementations, each of at least one connector includes a dual-sided elastic connection member. The dual-sided elastic connection member is connected to a first solder joint array in a first connection region and a target circuit board. The dual-sided elastic connection member may be a dedicated connector, or may be formed by adding spring plates or spring pins to two surfaces of an baffle PCB board. This is not specifically limited herein.

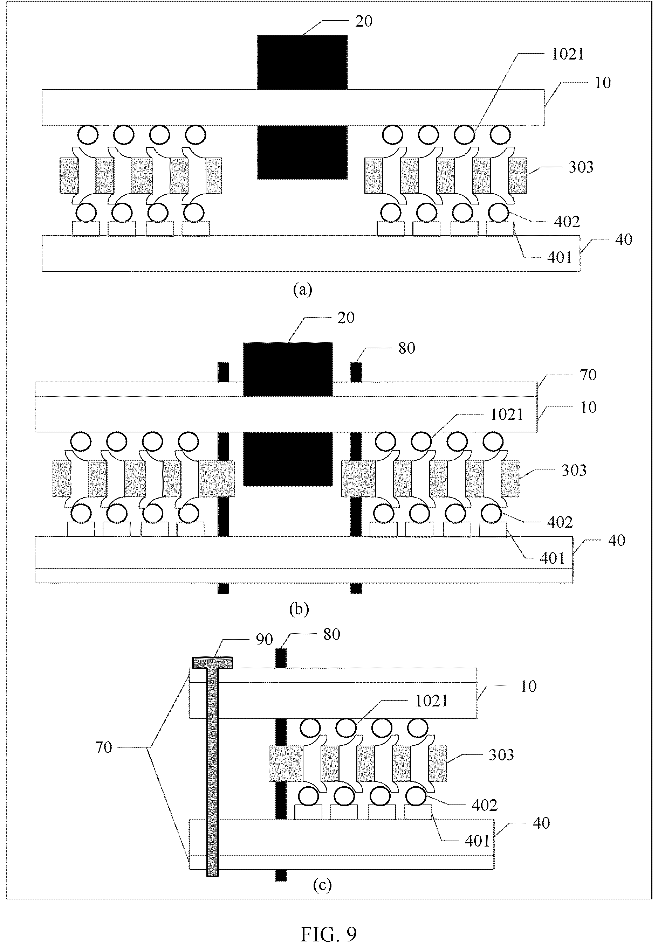

The following provides a description with reference to a diagram. Refer to FIG. 9. FIG. 9 is a diagram of a memory module according to this application. FIG. 9 includes a side view of the memory module, and an example in which first memory chips 20 are mounted on both surfaces of a first module PCB 10 is used.

As shown in (a) in FIG. 9, a spring plate or a spring pin on one surface of a dual-sided elastic connection member 303 is in contact with a first solder joint array in a first connection region, and a spring plate or a spring pin on the other surface is in contact with a pad 401 of a target circuit board 40. A solder joint 1021 is included in the first solder joint array.

In some optional implementations, as shown in (b) in FIG. 9, a guide pin hole may be further provided on the first module PCB board 10, and the guide pin hole is configured to insert a guide pin 80, to align the first module PCB 10 with a target circuit board 40. The guide pin 80 is connected to the first module PCB 10, a dual-sided elastic connection member 303, and the target circuit board 40 through the guide pin hole.

In some optional implementations, as shown in (c) in FIG. 9, a screw hole may be further provided on the first module PCB 10, and is configured to insert a screw 90, to reinforce a connection between the memory module and a target circuit board 40. The screw 90 is connected to the first module PCB 10 and the target circuit board 40 through the screw hole.

In addition, in the embodiment shown in (b) in FIG. 9, a structural reinforcing plate 70 is further connected on the first module PCB 10 and below the target circuit board 40. The structural reinforcing plate 70 is configured to strengthen a connection between the guide pin 80 and the first module PCB 10, a connection between the guide pin 80 and the dual-sided elastic connection member 303, and a connection between the guide pin 80 and the target circuit board 40. In the embodiment shown in (c) in FIG. 9, a structural reinforcing plate 70 is configured to: strengthen a connection between a guide pin 80 and the first module PCB 10, a connection between the guide pin 80 and a dual-sided elastic connection member 303, and a connection between the guide pin 80 and the target circuit board 40, and strengthen a connection between the screw 80 and the first module PCB 10 and a connection between the screw 80 and the target circuit board 40. Optionally, a structural reinforcing plate 70 may alternatively not be included in the memory module, but is used as a connection member in an assembly process of the memory module and used in cooperation with the memory module.

In some optional implementations, both a guide pin hole and a screw hole may be provided on the first module PCB 10, or only a guide pin hole or a screw hole may be provided on the first module PCB 10. This is not specifically limited herein.

In some optional implementations, a height of the first memory chip 20 is approximately 1.2 mm, a height of the first module PCB 10 is approximately 1.4 mm, and a height of the dual-sided elastic connection member 303 present after crimping is approximately 1.4 mm. If heights of a solder ball and a solder joint are ignored, an overall height of the memory module is approximately 4 mm. This can meet a height limit requirement of a high-density space.

Optionally, in a process of assembling the dual-sided elastic connection member 303 and the target circuit board 40, the spring pin or the spring plate may be aligned with a solder joint 402 and the pad 401, to solder the solder joint 402 to the pad 401.

In this application, a connector included in the memory module may alternatively be the dual-sided elastic connection member 303. A communication connection between the first module PCB 10 and the target circuit board 40 is established through contact between spring plates or spring pins on two surfaces. In this way, maintenance and replacement of the connector are more convenient, and practicability of the technical solutions of this application is further improved. In addition, if an baffle PCB board is used to replace a dedicated connector, a dedicated connector for mold opening is not required, and locations and a quantity of solder joints can be flexibly set. This further improves flexibility of the technical solutions of this application.

### 1.4. A connector includes a second enclosure baffle board and a conductive layer.

In some optional implementations, each of at least one connector includes a second enclosure baffle board, and each connector further includes a first conductive layer and/or a second conductive layer. The first conductive layer is connected to the second enclosure baffle board and a target circuit board, and the second enclosure baffle board is further soldered to a first solder joint array in a first connection region. The second conductive layer is connected to the second enclosure baffle board 304 and the first solder joint array in the first connection region, and the second enclosure baffle board is further soldered to the target circuit board. A structure of the second conductive layer is similar to that of the first conductive layer 305, but a location of the second conductive layer is different from that of the first conductive layer 305.

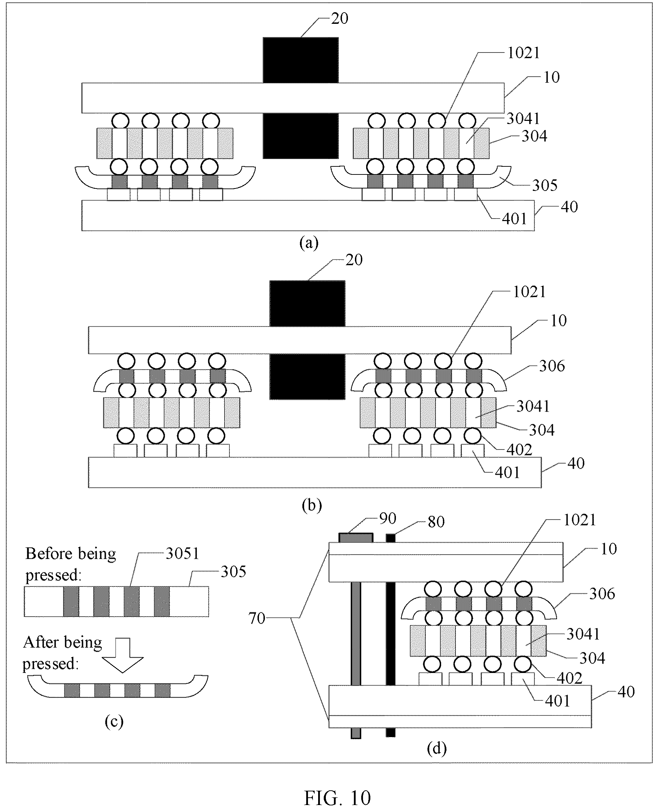

The following provides a description with reference to a diagram. Refer to FIG. 10. FIG. 10 is a diagram of a memory module according to this application. FIG. 10 includes a side view of the memory module, and an example in which first memory chips 20 are mounted on both surfaces of a first module PCB 10 is used.

As shown in (c) in FIG. 10, a via 3051 is provided on a first conductive layer 305, and the via 3051 is filled with a conductive material. After being pressed, the first conductive layer 305 has a lower height. The first conductive layer 305 includes a conductive fabric or a conductive film, and a via may be provided in plastic.

In some optional implementations, as shown in (a) in FIG. 10, a connector includes a second enclosure baffle board 304 and a first conductive layer 305. The second enclosure baffle board 304 may also be a PCB board. A via 3041 may be provided on the second enclosure baffle board 304, and the via 3041 is filled with a conductive material. A via of the first conductive layer 305, the via 3041 of the second enclosure baffle board 304, and a pad 401 of a target circuit board 40 are aligned in a crimping manner, and the via 3041 of the second enclosure baffle board 304 is further soldered to a first solder joint array in a first connection region. A solder joint 1021 is included in the first solder joint array. Optionally, in a process of assembling the second enclosure baffle board 304 and the first conductive layer 305, the via 3041, the solder joint, and the via of the first conductive layer 305 may be aligned, and the second enclosure baffle board 304 is soldered to the first conductive layer 305 through the solder joint.

In some optional implementations, as shown in (b) in FIG. 10, a connector includes a second enclosure baffle board 304 and a second conductive layer 306. A via of the second conductive layer 306, a via 3041 of the second enclosure baffle board 304, and a first solder joint array of a first connection region are aligned in a crimping manner, and the via 3041 of the second enclosure baffle board 304 is further soldered to a pad 401 of a target circuit board 40. Optionally, in a process of assembling the second enclosure baffle board 304 and the target circuit board 40, the via 3041, a solder joint 402, and the pad 401 may be aligned, and the second enclosure baffle board 304 is soldered to the pad 401 through the solder joint 402.

In some optional implementations, the connector may alternatively include a second enclosure baffle board 304, a first conductive layer 305, and a second conductive layer 306. That is, there are conductive layers on two sides of the second enclosure baffle board 304, and the conductive layers are respectively connected to the first module PCB 10 and a target circuit board 40. A specific connection manner between the first conductive layer 305 and the second conductive layer 306 is similar to that in (a) in FIG. 10 and (b) in FIG. 10. Details are not described herein again.

In some optional implementations, as shown in (d) in FIG. 10, a guide pin hole and a screw hole may be further provided on the first module PCB 10. The guide pin hole is configured to insert a guide pin 80, to align the first module PCB 10 with a target circuit board 40. The guide pin 80 is connected to the first module PCB 10 and the target circuit board 40 through the guide pin hole. The screw hole is configured to insert a screw 90, to reinforce a connection between the memory module and the target circuit board 40. The screw 90 is connected to the first module PCB 10 and the target circuit board 40 through the screw hole.

In addition, in the embodiment shown in (d) in FIG. 10, the memory module further includes a structural reinforcing plate 70. The structural reinforcing plate 70 is configured to: strengthen a connection between the guide pin 80 and the first module PCB 10 and a connection between the guide pin 80 and the target circuit board 40, and strengthen a connection between the screw 90 and the first module PCB 10 and a connection between the screw 90 and the target circuit board 40. Optionally, a structural reinforcing plate 70 may alternatively not be included in the memory module, but is used as a connection member in an assembly process of the memory module and used in cooperation with the memory module.

In the embodiment shown in (d) in FIG. 10, both the guide pin hole and the screw hole are provided on the first module PCB 10. During actual application, only a guide pin hole or a screw hole may alternatively be provided on the first module PCB 10. This is not specifically limited herein.

In some optional implementations, a height of the first memory chip 20 is approximately 1.2 mm, a height of the first module PCB 10 is approximately 1.4 mm, and a total height of the second enclosure baffle board 304 and the conductive layer present after crimping is approximately 1.4 mm. If heights of a solder ball and a solder joint are ignored, an overall height of the memory module is approximately 4 mm. This can meet a height limit requirement of a high-density space.

In this application, the connector in the memory module may alternatively include a second enclosure baffle board 304 and a conductive layer. An appearance of the conductive layer supports free cutting. This enriches application scenarios of the technical solutions of this application, and further improves flexibility. In addition, it can be learned from the foregoing description of the connector that, in this application, there are a plurality of possible connectors. The connector may be flexibly selected according to an actual application requirement. This enhances practicability of the technical solutions of this application.

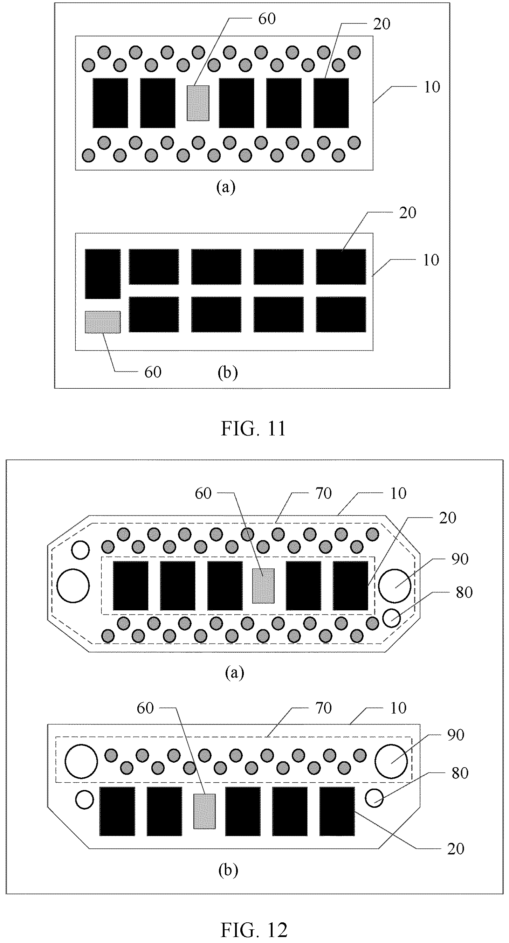

Next, refer to FIG. 11 and FIG. 12. FIG. 11 and FIG. 12 each are a top view of a memory module provided in this application, and an example in which nine first memory chips are mounted on a first module PCB 10 is used.

In both (a) in FIG. 11 and (b) in FIG. 11, an example in which a guide pin hole and a screw hole are not provided on the first module PCB 10, and an electrically erasable programmable read-only memory 60 is further mounted on the first module PCB 10 is used. (a) in FIG. 11 indicates a case in which the first memory chips 20 are arranged on both surfaces, and (b) in FIG. 11 indicates a case in which the first memory chips 20 are arranged on a single surface. When the first memory chips 20 are mounted on the both surfaces, five memory chips 20 may be mounted on a top surface of the first module PCB 10, and four memory chips 20 may be mounted on a bottom surface of the first module PCB 10; or vice versa. This is not specifically limited herein. Quantities of memory chips mounted on front and rear surfaces are equivalent. This is more conducive to balancing an area of the first module PCB 10.

For example, in a scenario in which the first memory chips 20 are mounted on the both surfaces, a first connection region may be shown in (a) in FIG. 11, and is located on two sides of the first memory chips 20. During actual application, the first connection region may alternatively be only on one side of the first memory chips 20. This is not specifically limited herein.

For example, in a scenario in which the first memory chips 20 are mounted on the single surface, a first connection region and the first memory chips 20 may be located on different surfaces of the first module PCB 10, so that the area of the first module PCB 10 can be further reduced, and a size of the memory module is never further reduced.

In both (a) in FIG. 12 and (b) in FIG. 12, an example in which a guide pin hole and a screw hole are provided on the first module PCB 10, and the first memory chips 20 are mounted on both surfaces of the first module PCB 10 is used. The guide pin hole is configured to insert a guide pin 80, and the screw hole is configured to insert a screw 90.

In the embodiment shown in (a) in FIG. 12, a first connection region is located on two sides of the first memory chips 20, a structural reinforcing plate 70 indicated by dashed boxes corresponds to the first connection region, and a structure similar to a shape of "concentric squares" is used. In the embodiment shown in (b) in FIG. 12, a first connection region is located on a single side of the first memory chips 20, so that a width of the first module PCB 10 can be reduced. A structural reinforcing plate 70 indicated by a dashed box is of a rectangular structure.

In a case in which the nine first memory chips are also mounted, the guide pin hole and the screw hole in the memory module shown in FIG. 12 occupy a specific space. Therefore, in comparison with the example in FIG. 11, a length of the first module PCB 10 shown in FIG. 12 is increased. Optionally, the length of the first module PCB 10 is increased by approximately 15 mm.

In some optional implementations, the first module PCB 10 shown in FIG. 11 is approximately 63 mm in length and approximately 23 mm in width. A width of the first module PCB 10 shown in (b) in FIG. 11 may be smaller. The first module PCB 10 shown in FIG. 11 is approximately 78 mm in length and approximately 23 mm in width. A width of the first module PCB 10 shown in (b) in FIG. 12 may be smaller. In addition, a diameter of a solder joint corresponding to the first connection region on one side of the first memory chips 20 may be set to approximately 0.5 mm, a spacing between solder joints is approximately 1 mm, and a quantity of pins of corresponding solder joints is approximately 200.

It should be noted that FIG. 11 and FIG. 12 are merely examples of the memory module, and do not constitute a limitation on the memory module provided in this application. During actual application, the memory module may further include more or fewer first connection regions and first memory chips 20, and a size of the first module PCB 10 may alternatively be larger or smaller. This is not specifically limited herein.

### 2. A memory module is soldered to a target circuit board.

The foregoing describes a solution in which when a memory module includes a single module PCB, the module PCB is connected to a target circuit board through a connector. The following describes a solution in which a module PCB is directly soldered to a target circuit board.

In this case, a memory module includes a first assembly, and the first assembly includes a first module PCB and at least one first memory chip.

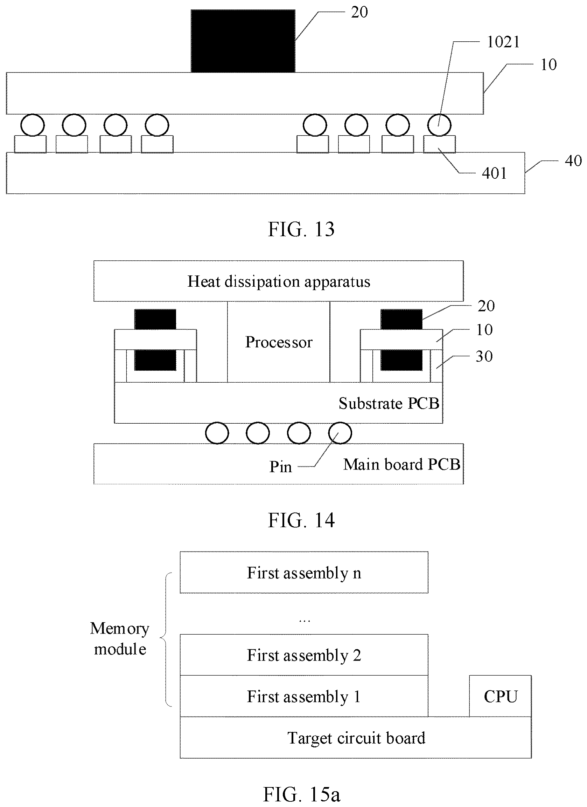

For clarity of description, the following further describes the memory module with reference to a diagram. Refer to FIG. 13. FIG. 13 is a diagram of a memory module according to an embodiment of this application.

As shown in FIG. 13, a first module PCB 10 is parallel to a target circuit board 40. The first module PCB 10 includes a first memory region and a first connection region. The first memory region is located on a T surface of the first module PCB 10 and is configured to mount at least one first memory chip 20. The first connection region is located on a B surface of the first module PCB 10, and includes a first solder joint array. The first solder joint array includes a plurality of solder joints, and indicates soldering locations. A solder joint 1021 is included in the first solder joint array. The first solder joint array is configured to solder the first module PCB 10 to the target circuit board 40, to establish a communication connection between the first module PCB 10 and the target circuit board 40.

Similar to the embodiment shown in FIG. 4, in a case in which the memory module is soldered to the target circuit board 40, the solder joints included in the first connection region are arranged in a plurality of manners. Details are not described herein again.

In addition, first memory chips 20 mounted on a single surface may also be arranged in a plurality of manners: a long edge of each first memory chip 20 may be perpendicular to or parallel to a long edge of the first module PCB 10; or a long edge of a part of the first memory chips 20 may be perpendicular to a long edge of the first module PCB 10, and a long edge of the other part of the first memory chips 20 may be parallel to a long edge of the first module PCB 10. In addition, there is another possible arrangement manner of the first memory chips 20. For example, a long edge of the first memory chip 20 is neither perpendicular to nor parallel to the long edge of the first module PCB 10. This is not specifically limited herein.

In some optional implementations, a height of the first memory chip 20 is approximately 1.2 mm, and a height of the first module PCB 10 is approximately 1.4 mm. If heights of a solder ball and a solder joint are ignored, an overall height of the memory module is approximately 2.6 mm. This can meet a height limit requirement of a high-density space.

In this application, a communication connection to the target circuit board 40 is implemented through the solder joint array in the connection region on the first module PCB 10. No gold finger or insertion slot needs to be disposed, and an area of a connection region in the memory module is smaller. In this way, in a case of a module PCB with a same area, more memory chips can be mounted, to meet a requirement of a high-density small space. In addition, in a solution in which the memory module is directly soldered to the target circuit board 40 through the first solder joint array on the first module PCB 10, because the first solder joint array and the first memory region for mounting the first memory chip 20 are located on different surfaces of the first module PCB 10, arrangement of the first solder joint array does not affect mounting of the first memory chip 20, and the first solder joint array may not be considered when a size of the first module PCB 10 is set. This can further reduce a size of the memory module. In addition, directly soldering the first module PCB 10 to the target circuit board 40 can further reduce the height of the memory module and further implement component miniaturization.

It should be noted that, for the memory module (that is, including the first module PCB 10 and the first memory chip 20) shown in FIG. 13, in an actual assembly process, the memory module may also be used in cooperation with a connector. That is, the connector may be connected between the first module PCB 10 and the target circuit board 40. A specific type and an assembly manner of the connector are similar to "1. A memory module is connected to a target circuit board through a connector" described above. Details are not described herein again.

The target circuit board described in this application includes a main board and a substrate. The following uses an example in which the target circuit board is a base station for description with reference to a diagram. Refer to FIG. 14. FIG. 14 is a diagram of a memory module according to an embodiment of this application.

A scenario shown in FIG. 14 is mounting of a substrate PCB of a chip die. As shown in FIG. 14, first memory chips 20 are mounted on both surfaces of a first module PCB 10 in the memory module, the first module PCB 10 is connected to the substrate PCB through a connector 30, and the substrate PCB is connected to a main board PCB through a pin. In general, the memory module provided in this application supports mounting of the main board PCB in a high-density scenario, and also supports mounting of a package substrate PCB of the chip die. This further enriches application scenarios of the technical solutions of this application.

It should be noted that, in the foregoing description, an example in which the memory module is of an open frame structure is used for description. During actual application, the memory module may alternatively be packaged. In other words, the memory module further includes a package housing, and a first assembly is located in the package housing.

### II. A memory module includes a plurality of module PCBs.

In this case, there are a plurality of possible location relationships between the plurality of module PCBs. These are separately described below.

### 1. Planes on which a plurality of module PCBs are located are parallel.

For clarity of description, refer to FIG. 15a. FIG. 15a is a diagram of a memory module according to an embodiment of this application.

As shown in FIG. 15a, the memory module includes a plurality of first assemblies, and a plurality of first module PCBs in the plurality of first assemblies are parallel. A target circuit board shown in FIG. 15a is a main board or a substrate. A connection manner between a first assembly 1 and the target circuit board is similar to a connection manner between the memory module and the target circuit board through the connector described in the foregoing related description of "I. A memory module includes a single module PCB". Details are not described herein again.

In addition, a connection manner between the plurality of first assemblies is similar to a connection manner between the first module PCB and the target circuit board in "1. A memory module is connected to a target circuit board through a connector" described above. It should be noted that, in this scenario, the target circuit board is a module PCB. For example, when a first assembly 2 shown in FIG. 15a is connected to the first assembly 1, for the first assembly 2, a first module PCB in the first assembly 1 is a target circuit board.

It should be noted that a quantity of first assemblies included in the memory module, and a quantity of first memory chips mounted on each first assembly and a manner of mounting the first memory chips to the first assembly are not limited in this application. In consideration of component normalization, a connection manner between the first assemblies may be the same as a connection manner between the first assembly and the target circuit board. However, during actual application, a connection manner between the first assemblies may alternatively be different from a connection manner between the first assembly and the target circuit board. This is not specifically limited herein. In addition, a screw hole and/or a guide pin hole may be started on a first module PCB in each first assembly, to insert a screw and/or a guide pin. The screw is configured to reinforce a connection between the first assemblies and a connection between the first assembly and the target circuit board, and the screw is configured to align the plurality of first assemblies with the target circuit board. In addition, in a case in which a guide pin hole or a screw hole is started on the first module PCB, in an assembly process, the memory module may further cooperate with a structural reinforcing plate, to reinforce a connection between components.

In this application, the memory module may include a single module PCB, to meet a miniaturization requirement more easily; or may include a plurality of module PCBs, to mount memory chips as many as possible and expand a memory capacity.

### 2. Planes on which a plurality of module PCBs are located intersect.

In this case, a memory module includes a first assembly and a second assembly. The first assembly is described in detail above. Details are not described herein again. The second assembly includes a second module PCB and at least one second memory chip. A plane on which the second module PCB is located intersects a plane on which a first module PCB is located. The second module PCB is configured to mount the at least one second memory chip.

A first connection region on the first module PCB further includes a second solder joint array, and the second solder joint array and a first solder joint array are located on different surfaces of the first module PCB. The second solder joint array is configured to connect the first module PCB to the second module PCB.

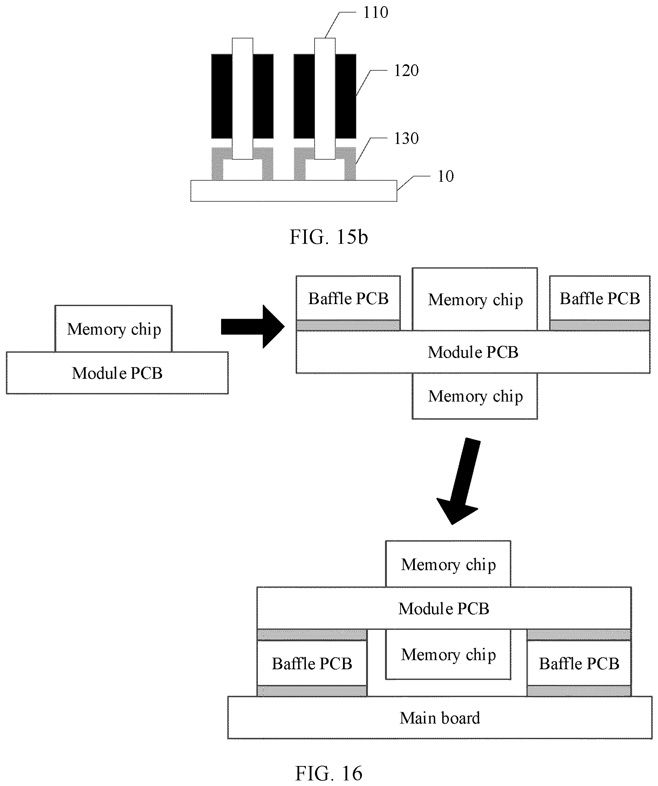

For example, refer to FIG. 15b. FIG. 15b is a diagram of a memory module according to this application, including a side view of the memory module.

In the embodiment shown in FIG. 15b, the memory module includes a first module PCB 10 and two second module PCBs 110. Second memory chips 120 are mounted on front and rear surfaces of each second module PCB 110. A plane on which the second module PCB 110 is located is perpendicular to a plane on which the first module PCB 10 is located.

The first module PCB 10 includes a first solder joint array and a second solder joint array, and the first solder joint array and the second solder joint array are located on different surfaces of the first module PCB 10. The first solder joint array is configured to implement a connection between the first module PCB 10 and a target circuit board. A specific connection manner is similar to that in the foregoing description. Details are not described herein again. In addition, a first memory chip may further be mounted on the first module PCB 10.

The second solder joint array is configured to solder the first module PCB 10 to the plurality of second module PCBs 110. In the implementation shown in FIG. 15b, the second module PCB 120 is connected to the first module PCB 130 through a connection member. The connection member may be a metal component, for example, a copper pillar. This is not specifically limited herein. The connection member 130 is connected to a second connection region on the second module PCB 110 and the second solder joint array on the first module PCB 10, to establish communication between the first module PCB 10 and the second module PCB 110.

It should be noted that FIG. 15b is merely an example in which a plurality of module PCBs intersect. During actual application, the second module PCB may not be perpendicular to the first module PCB, provided that the second module PCB intersects the first module PCB; and the plurality of second module PCBs may be parallel to each other, or may not be parallel. A manner of mounting a second memory chip on each second module PCB is similar to the manner of mounting the first memory chip on the first module PCB described above. This is not specifically limited herein.

In this application, a location relationship between the plurality of module PCBs in the memory module may be that the plurality of module PCBs are parallel to each other or intersect. In other words, when the memory module provided in this application includes the plurality of module PCBs, the memory module is of a plurality of structures. This enriches implementations of the technical solutions of this application.

It should be noted that the memory module provided in this application may be manufactured in an open frame manner, or may be packaged. The following briefly describes an open frame manufacturing process and a packaging manufacturing process with reference to a diagram.

Refer to FIG. 16. FIG. 16 is a diagram of a processing procedure of a memory module according to an embodiment of this application.

In FIG. 16, an example in which a connector in the memory module is a PCB baffle board and a processing manner is an open frame manner is used. During soldering, a memory chip may be first soldered on a T surface of a module PCB, then a memory chip and the PCB enclosure baffle board are soldered on a B surface of the module PCB, and finally, the memory module is soldered to a T surface of a main board. A gray shaded part in FIG. 16 indicates solder paste for soldering.

If the memory module is packaged, after a connector is connected to a module PCB, a packaging material may be filled between the connector, the module PCB, and a memory chip. To ensure normal communication between the memory module and the target circuit board, the connector usually exposes the packaging material. In this case, the connector may be further ground, so that the connector is on a same horizontal plane as a surface connected to the target circuit board. In addition, before different assemblies are soldered or packaged, the assemblies may be further cleaned, and a cleaning manner may be plasma (plasma) cleaning. After packaging, a surface of the memory module may be further metalized. This facilitates heat dissipation of the memory module. In addition, a 3w molding material may be used for molding. This is also conducive to heat dissipation. For signal arrangement of the memory module, refer to a standard DIMM.

It should be noted that the memory module provided in this application may include a single module PCB or a plurality of module PCBs regardless of that the memory module is in an open frame form or a packaging form.

In the foregoing description, the single memory module is described. The following further describes the memory module provided in this application with reference to a specific application scenario.

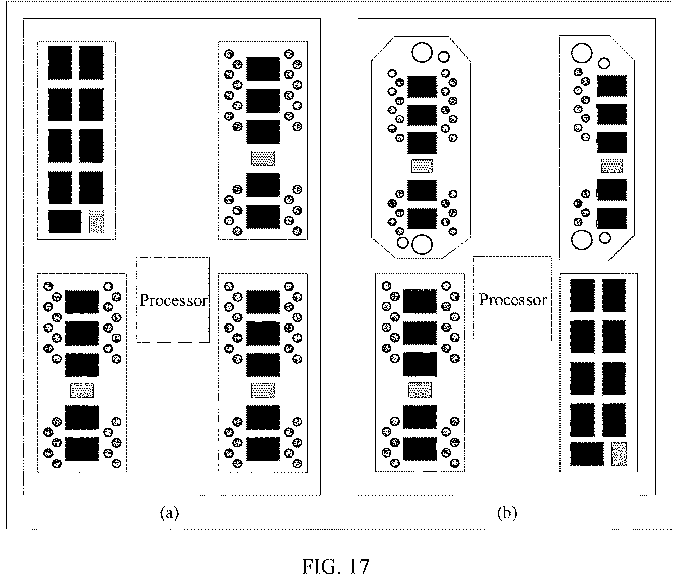

Refer to FIG. 17. FIG. 17 is a diagram of a main board according to an embodiment of this application. The following provide description by using an example in which a processor shown in FIG. 17 is a CPU, the CPU supports four DDR channels, and each memory module on the main board supports one DDR channel.

As shown in (a) in FIG. 17, memory modules of two different structures may be assembled on the main board. Specific structures of the two memory modules are similar to that of the memory module shown in FIG. 11. Details are not described herein again. During actual application, the main board may further include memory modules of more different structures, as shown in (b) in FIG. 17. Specific structures of memory modules shown in (b) in FIG. 17 are similar to those of memory modules shown in FIG. 11 and FIG. 12. Details are not described herein again.

It should be noted that FIG. 17 is merely an example of assembling the memory module on the main board. During actual application, the CPU may further support more or fewer DDR channels, one memory module may alternatively support a plurality of DDR channels, and more or fewer memory modules may be assembled on the main board. This is not specifically limited herein.

During actual application, a conventional DIMM has a large size, and cannot be installed in a high-density small space. In a conventional method, an on-board chip is used, to use a memory chip in a high-density small space. Specifically, the memory chip is directly soldered to a DDR layout space on the main board. In this method, when the CPU is connected to the on-board chip, a problem of cross routing is likely to occur. To compare the cross routing, a routing layer is added. As a result, a quantity of routing layers is increased, and lines are complex. When the memory module provided in this embodiment of this application is connected to the CPU, cross routing is transferred to the memory module, so that a quantity of layers of a main board PCB (namely, a target circuit board) can be reduced.

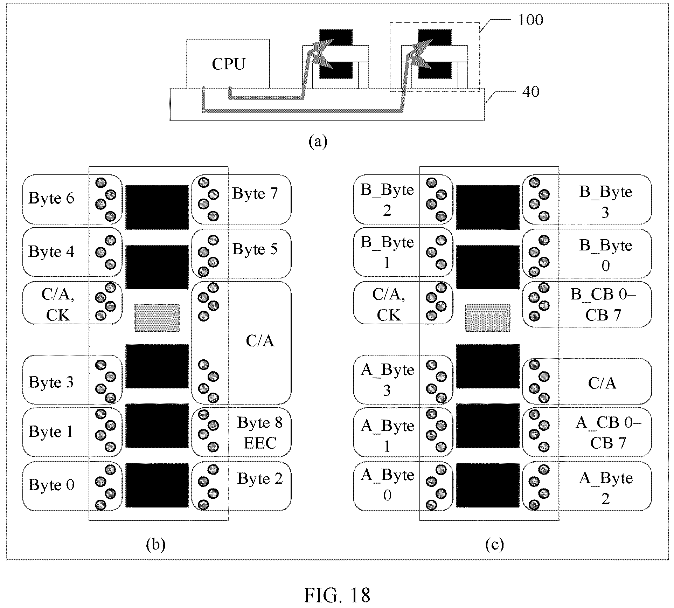

The following describes routing for the memory module provided in this application with reference to a diagram. Refer to FIG. 18 to FIG. 19b. FIG. 18 to FIG. 19b each are a diagram of routing for a memory module according to an embodiment of this application.
(a) in FIG. 18 is a simple example of routing between a CPU and memory modules 100 on a target circuit board 40. Arrows in the figure indicate a routing principle, and traces between different memory modules 100 and the CPU do not cross. That the traces do not cross herein means that a data (data) trace on the target circuit board 40 does not cross a DDR command (command)/address (address) signal trace and a DDR clock (clock, CK) signal trace. A command/address signal is also briefly referred to as a C/A(C/A) signal. In addition, on a target circuit board 40 with a thickness of 2 mm, a DDP chip trace may be supported. In comparison with a layout manner of on-board chips, 4 to 8 routing layers can be reduced. This further implements miniaturization.
   The memory module provided in this application supports DDRs and LPDDRs of various generations, and supports a single-die memory chip, a multi-die memory chip, and a multi-layer memory chip. Memory chip arrangement supports single-rank and multi-rank.
(b) in FIG. 18 and (c) in FIG. 18 show examples of signal arrangement of memory modules with memory chips being a DDR4 and a DDR5 provided in this application present, with respective reference to standard signal arrangement of a DDR4 DIMM and a DDR5 DIMM. In addition, a gray circle in the figure indicates a pin, a black rectangle indicates a memory chip, and a gray small rectangle indicates an electrically erasable programmable read-only memory.

In (b) in FIG. 18, an example in which a memory chip in a memory module is a DDR4, and the memory module supports one DDR channel is used. As shown in (b) in FIG. 18, pins in an upper half part of the memory module are connected to a part of data signal interfaces, a part of C/A signal interfaces, and a CK signal interface of a processor, and the part of the data signal interfaces corresponds to a byte (byte) 4 to a byte 7. Pins in a lower half part of the memory module are connected to the other part of the data signal interfaces and the other part of the C/A signal interfaces of the processor, and the part of the data signal interfaces corresponds to a byte 0 to a byte 3.

In (c) in FIG. 18, an example in which a memory chip in a memory module is a DDR5, and the memory module supports two DDR channels is used. It is assumed that the two DDR channels are a channel A and a channel B. As shown in (c) in FIG. 18, pins of an upper half part of the memory module are connected to a part of data signal interfaces, a part of C/A signal interfaces, and a CK signal interface of the channel B of a processor, and the part of the data signal interfaces corresponds to a byte 0 to a byte 3 (B_Byte 0 to B_Byte 3 shown in the figure) of the channel B. Pins in a lower half part of the memory module are connected to a part of data signal interfaces and a part of C/A signal interfaces of the channel A of the processor, and the part of the data signal interfaces corresponds to a byte 0 to a byte 3 (A_Byte 0 to A_Byte 3 shown in the figure) of the channel A.

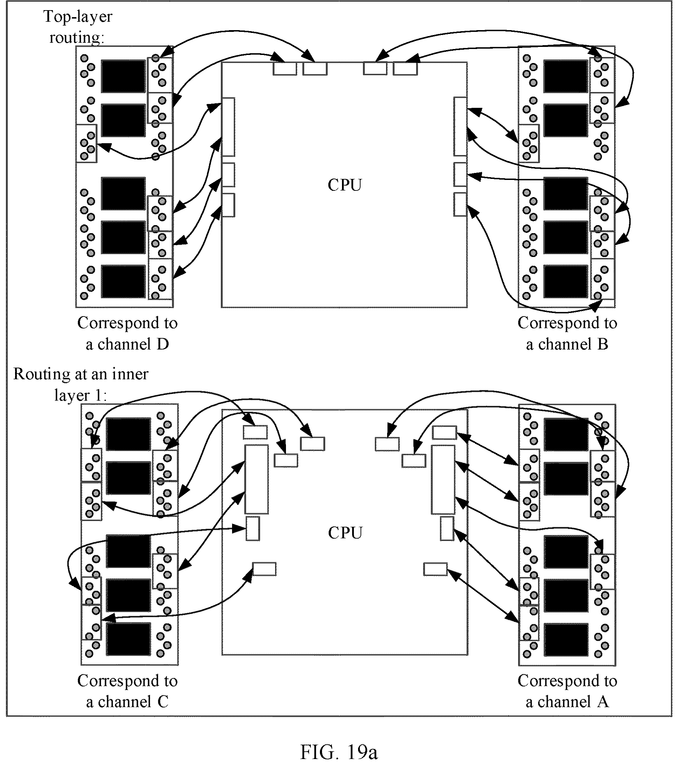

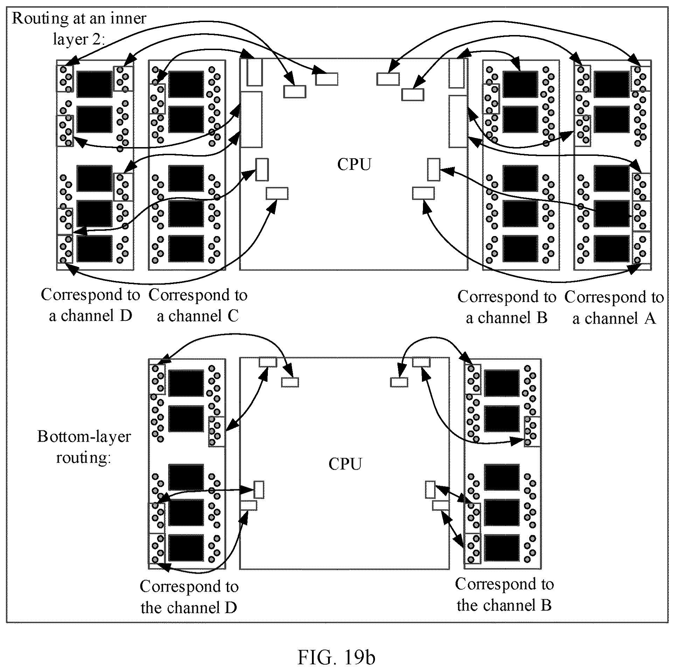

FIG. 19a and FIG. 19b further describe routing between memory modules and CPUs provided in this application by using an example in which a memory chip is a DDR4 and the CPU supports four DDR channels. The four DDR channels are a channel A, a channel B, a channel C, and a channel D. In addition, in embodiments shown in FIG. 19a and FIG. 19b, there are two memory modules on each side of the CPU, and from left to right, the four memory modules respectively correspond to the channel D, the channel C, the channel B, and the channel A.

FIG. 19a includes top-surface routing and routing at an inner layer 1 on a target circuit board. In the top-surface routing, memory modules corresponding to the channel D and the channel B are connected to a CPU. In the routing at the inner layer 1, memory modules corresponding to the channel C and the channel A are connected to a CPU.

As shown in FIG. 19a, in the top-surface routing: from left to right, four interfaces at the top of the CPU are a byte 1 signal interface of the channel D, a byte 0 signal interface of the channel D, a byte 0 signal interface of the channel B, and a byte 1 signal interface of the channel B; from top to bottom, leftmost three interfaces of the CPU are a C/A signal interface of the channel D, a byte 4 signal interface of the channel D, and a byte 6 signal interface of the channel D; and from top to bottom, rightmost three interfaces of the CPU are a C/A signal interface of the channel B, a byte 4 signal interface of the channel B, and a byte 6 signal interface of the channel B. These interfaces are connected to pins in corresponding regions in the memory modules, to complete the top-surface routing.

As shown in FIG. 19a, in the routing at the inner layer 1: from top to bottom, leftmost four interfaces of the CPU are a byte 8 signal interface of the channel C, a C/A signal interface of the channel C, a byte 5 signal interface of the channel C, and a byte 7 signal interface of the channel C; from top to bottom, rightmost four interfaces of the CPU are a byte 8 signal interface of the channel A, a C/A signal interface of the channel A, a byte 5 signal interface of the channel A, and a byte 7 signal interface of the channel A; and from left to right, four interfaces in an upper middle part of the CPU are a byte 3 signal interface of the channel C, a byte 1 signal interface of the channel C, a byte 1 signal interface of the channel A, and a byte 3 signal interface of the channel A. These interfaces are connected to pins in corresponding regions in the memory modules, to complete the top-surface routing.

FIG. 19b includes routing at an inner layer 2 and bottom-surface routing on the target circuit board. In the routing at the inner layer 2, the memory modules corresponding to the channel A to the channel D are connected to a CPU. In the bottom-surface routing, the memory modules corresponding to the channel D and the channel B are connected to a CPU.

As shown in FIG. 19b, in the routing at the inner layer 2: from top to bottom, leftmost four interfaces of the CPU are a byte 8 signal interface of the channel D, a C/A signal interface of the channel C, a byte 4 signal interface of the channel C, and a byte 6 signal interface of the channel C; from top to bottom, rightmost four interfaces of the CPU are respectively a byte 8 signal interface of the channel B, a C/A signal interface of the channel A, a byte 4 signal interface of the channel A, and a byte 6 signal interface of the channel A; and from left to right, four interfaces in an upper middle part of the CPU are a byte 2 signal interface of the channel C, a byte 0 signal interface of the channel C, a byte 0 signal interface of the channel A, and a byte 2 signal interface of the channel A. These interfaces are connected to pins in corresponding regions in the memory modules, to complete the routing at the inner layer 2.

As shown in FIG. 19b, in the bottom-surface routing: from left to right, four interfaces at the top of the CPU are a byte 3 signal interface of the channel D, a byte 2 signal interface of the channel D, a byte 2 signal interface of the channel B, and a byte 3 signal interface of the channel B; and from left to right, four interfaces in a lower part of the CPU are a byte 7 signal interface of the channel D, a byte 5 signal interface of the channel D, a byte 5 signal interface of the channel B, and a byte 7 signal interface of the channel B. These interfaces are connected to pins in corresponding regions in the memory modules, to complete the bottom-surface routing.

With reference to FIG. 19a and FIG. 19b, it can be learned that the memory modules cooperate with the CPU, to complete DDR routing at four routing layers (the top-surface routing, the bottom-surface routing, and routing at the two inner layers). In addition, it should be noted that FIG. 19a and FIG. 19b are merely examples of routing on the target circuit board, and do not constitute a limitation on this application.

In general, in the memory modules provided in this application, in a case of a same quantity of chips, an area and a height of a SO-DIMM are smaller than those of a DIMM. In comparison with an on-board SDP chip on a main board, the target circuit board is reduced from A+4 layers to A layers, and a quantity of layers is reduced by 4. This reduces costs by at least 30%. Second, the memory module can support larger-capacity DDP chips. This improves supply and increases a memory capacity. In addition, chips on front and rear surfaces of a module PCB can be ventilated and dissipated. In comparison with an on-board chip on a B surface of the main board, heat dissipation of chips is improved. In addition, the module supports a crimping contact mode. This is convenient for decoupling the module from the main board, mounting, and disassembly, and more convenient for production, processing, testing, debugging, and maintenance.

In some optional implementations, in a standard card scenario, there is little cross between CPU signal arrangement and DIMM trace cross, and a conventional DIMM size cannot meet a layout requirement of a standard card. The main board has an on-board chip, and there is much cross between traces on the main board. In this case, a DDP chip needs to be supported, a quantity of DDR address/command signal routing layers is increased, and a quantity of layers of a main board PCB is at least B+8. A board thickness of a standard card PCB with a gold finger is 1.57 mm. The board thickness of 1.57 mm supports a maximum of B+2 layers. The board thickness of the PCB needs to be increased to 2.6 mm, to increase a quantity of layers to B+8. A special process of a PCB ladder gold finger is required. Costs of the PCB are high. In the technical solutions of this application, a region with much cross between traces is transferred to the memory module, and PINMAP signal arrangement of the memory module is made with reference to an existing DIMM. This reduces cross between traces on the main board. According to the memory module provided in this application, only a quantity B of layers of the standard card PCB is required to be reduced by eight. In addition, a special process of a ladder gold finger is not required, and costs of the PCB are reduced by more than 60%.

In general, in comparison with an existing technical solution, in the present invention, it is ensured that a length, a width, and a height of a high-density module are smaller than those of an existing DIMM and SO-DIMM, and a high-density layout is supported. In addition, DDR cross routing of a DDP memory chip is transferred to the memory module. A quantity of layers of a main board PCB of the standard card is reduced by 8. In addition, a special process of a ladder gold finger is avoided. This further reduces costs.

In some optional implementations, in a typical CPU module scenario, a layout area on a single side of a CPU is approximately 35 mm×140 mm. If the CPU needs to support eight DDR channels, a total of 160 pcs of memory chips need to be arranged, and 20 pcs of memory chips need to be arranged in each channel. However, in an on-board chip solution, an area of 68 mm×30 mm on the main board PCB is insufficient for arranging 40 pcs of chips. This cannot meet an actual application requirement. According to the memory module provided in this application, memory chips are attached to a module PCB by using an SMT, a high-density memory module with a smaller length, a smaller width, and a smaller height is made by using a high-density process, the module PCB is raised by using a connector, and then the module PCB is mounted on the main board through soldering or crimping contact. The memory chips can be mounted on both surfaces of the module PCB. In addition, the memory module provided in this application supports the main board PCB, and also supports mounting of a package substrate PCB of a chip die (for example, as shown in FIG. 14), to further resolve a layout space problem.

In addition, this application further provides an electronic device, including a main board, a processor, a housing, and at least one of the foregoing memory modules. The memory module is electrically connected to the processor through the main board, the memory module is configured to store data, and the processor is configured to process the data in the memory module.

In the several embodiments provided in this application, it should be understood that the disclosed system and apparatus may be implemented in other manners. For example, the described apparatus embodiments are merely examples. For example, division of the units is merely logic function division and may be other division during actual implementation. For example, a plurality of units or assemblies may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

## Claims

1. A memory module, comprising:
a first assembly, wherein the first assembly comprises a first module printed circuit board PCB and at least one first memory chip;
the first module PCB comprises a first memory region and a first connection region, and the first connection region comprises a first solder joint array; and
the first memory region is configured to mount the at least one first memory chip, and the first solder joint array is configured to implement a connection between the first module PCB and a target circuit board, to establish a communication connection between the first module PCB and the target circuit board.

2. The memory module according to claim 1, wherein the first assembly further comprises at least one connector; and
that the first solder joint array is configured to implement the connection between the first module PCB and the target circuit board comprises:
connecting the first solder joint array to the target circuit board through the at least one connector.

3. The memory module according to claim 2, wherein each of the at least one connector comprises a first enclosure baffle board; and
a via is provided in the first enclosure baffle board, and the via of the first enclosure baffle board is soldered to the first solder joint array and the target circuit board.

4. The memory module according to claim 2, wherein each of the at least one connector comprises a single-sided elastic connection member; and
an elastic surface of the single-sided elastic connection member is connected to the first solder joint array, and a non-elastic surface of the single-sided elastic connection member is soldered to the target circuit board; or
an elastic surface of the single-sided elastic connection member is connected to the target circuit board, and a non-elastic surface of the single-sided elastic connection member is soldered to the first solder joint array.

5. The memory module according to claim 2, wherein each of the at least one connector comprises a dual-sided elastic connection member; and
the dual-sided elastic connection member is connected to the first solder joint array and the target circuit board.

6. The memory module according to claim 2, wherein each of the at least one connector comprises a second enclosure baffle board, and each connector further comprises a first conductive layer and/or a second conductive layer;
the first conductive layer is connected to the second enclosure baffle board and the target circuit board, and the second enclosure baffle board is further soldered to the first solder joint array; and
the second conductive layer is connected to the second enclosure baffle board and the first solder joint array, and the second enclosure baffle board is further soldered to the target circuit board.

7. The memory module according to any one of claims 1 to 6, wherein the memory module further comprises a second assembly;
the second assembly comprises a second module PCB and at least one second memory chip, and a plane on which the second module PCB is located intersects a plane on which the first module PCB is located;
the first connection region further comprises a second solder joint array, and the second solder joint array and the first solder joint array are located on different surfaces of the first module PCB;
the second module PCB is configured to mount the at least one second memory chip; and
the second solder joint array is configured to connect the first module PCB to the second module PCB.

8. The memory module according to any one of claims 1 to 7, wherein the first memory region is located on a single surface or both surfaces of the first module PCB.

9. The memory module according to any one of claims 1 to 6, wherein the memory module further comprises a package housing, and the first assembly is located in the package housing.

10. An electronic device, comprising: a main board, a processor, a housing, and at least one memory module according to any one of claims 1 to 9, wherein
the memory module is electrically connected to the processor through the main board.
